# EUROPEAN PATENT SPECIFICATION

(11) **EP 3 314 163 B1**
(45) Date of publication and mention of the grant of the patent: **21.08.2019**
(21) Application number: 16753464.3
(22) Date of filing: 29.06.2016
(51) Int. Cl.: F21V 19/00, F21S 4/00, F21V 23/06, F21S 4/28, F21V 23/00, F21Y 115/10, F21Y 103/10, F21Y 113/00, H05K 3/40

(54) **A LIGHTING DEVICE AND CORRESPONDING METHOD**
BELEUCHTUNGSVORRICHTUNG UND ZUGEHÖRIGES VERFAHREN
DISPOSITIF D'ÉCLAIRAGE ET PROCÉDÉ CORRESPONDANT

(30) Priority: 29.06.2015 IT UB20151752
(43) Date of publication of application: 02.05.2018
(73) Proprietor: OSRAM GmbH, 80807 München (DE); OSRAM S.P.A. - SOCIETA' RIUNITE OSRAM EDISON CLERICI, 20126 Milano (IT)
(72) Inventor: BOBBO, Simon, 30035 Mirano (Venezia) (IT); MICHIELAN, Valerio, 31021 Mogliano Veneto (Treviso) (IT); ZANOTTO, Alberto, 35127 Padova (IT)
(74) Representative: Bosotti, Luciano
(86) International application number: PCT/IB2016/053880
(87) International publication number: WO 2017/002029

(56) References cited:
- WO-A1-2013/068532
- WO-A2-2013/160834
- DE-U1-202012 102 874
- US-A- 4 999 755
- US-A1- 2003 103 347
- US-A1- 2007 285 949
- US-A1- 2010 328 947
- US-A1- 2012 002 427

## Description

### Technical Field

The present description relates to lighting devices.

One or more embodiments may refer to lighting devices employing electrically-powered light radiation sources, e.g. solid-state light radiation sources, such as LED sources.

### Technological Background

The market offers lighting devices implemented as flexible linear modules ("flex modules").

In most installations, the installer and/or the end user of such devices is virtually forced to use a fixed configuration in terms of:
- luminous flux;
- colour temperature (CCT) for white light;
- colour of the emitted radiation;
- light emission pattern.

The fixed configuration, moreover, implies the impossibility of locally modifying one or more of the previously listed features along the extension of the module.

In most current applications, the possibility of modifying the emission features of the light radiation sources are limited to interventions such as:
- the variation of the luminous flux, e.g. via a dimmer;
- the change of the colour temperature (CCT), achievable e.g. through the use of a tuneable white module;
- the change of the light colour, via an RGB module provided with a programmable power supply;
- the change of the light emission pattern, by using different LED modules (e.g. as regards LED pitch) or by using accessories such as diffusive screens, lenses etc.

In any case, all these possibilities are based on specific and different solutions for the LED module and the respective power supply.

The need is therefore felt to obtain an improved flexibility in varying one or more of the previously listed features, specifically along the module length, and/or giving the possibility of varying such a feature in the course of time, therefore adapting the installation to the needs of the end user. Document US 2012/002427 A1 discloses a lighting device according to the preamble of claim 1; additionally, documents US 4999755 A, US 2007/285949 A1, DE 202012102874 U1 and US 2003/103347 A1 may be of some interest for the present disclosure.

### Object and Summary

One or more embodiments aim at satisfying such need.

According to one or more embodiments, said object is achieved thanks to a lighting device having the features specifically set forth in the claims that follow.

One or more embodiments may also concern a corresponding method.

The claims are an integral part of the technical teaching provided herein with reference to the embodiments.

One or more embodiments may lead to the achievement of one or more of the following advantages, giving the possibility of:
- implementing both linear and profiled installations;
- changing the luminous flux;
- changing the colour temperature;
- changing the colour of the light radiation;
- changing the pitch between the sources (e.g. LED sources);
- changing the light emitting pattern via secondary optics or screens positioned on the sources;
- easily changing the position of the light module;
- easily changing the length of the lighting modules.

### Brief Description of the Figures

One or more embodiments will now be described, by way of non-limiting example only, with reference to the annexed Figures, wherein:
- Figure 1 is a perspective view of an element of a lighting device according to embodiments;
- Figure 2 is a section along line II-II of Figure 1, shown in an enlarged scale;
- Figures 3 to 5, with Figure 4 corresponding to a view along arrow IV of Figure 3, show implementation for a lighting device according to one or more embodiments, by employing an element as shown in Figures 1 and 2;
- Figures 6 and 7 show a connector which may be used in one or more embodiments, shown separately (Figure 6) and in the mounted condition on a lighting device (Figure 7); and
- Figures 8 to 10 show various possibilities of employing one or more embodiments.

It will be appreciated that, for ease of understanding, the views in the various Figures may not be drawn to the same scale.

### Detailed Description

In the following description, numerous specific details are given to provide a thorough understanding of exemplary embodiments. One or more embodiments may be practiced without one or several of the specific details, or with other methods, components, materials, etc. In other instances, well-known structures, materials, or operations are not shown or described in detail to avoid obscuring various aspects of the embodiments.

Reference throughout this specification to "one embodiment" or "an embodiment" means that a particular feature, structure, or characteristic described in connection with the embodiment is included in at least one embodiment. Thus, the possible appearances of the phrases "in one embodiment" or "in an embodiment" in various places throughout this specification are not necessarily all referring to the same embodiment. Furthermore, particular features, structures, or characteristics may be combined in any suitable manner in one or more embodiments.

The headings provided herein are for convenience only, and therefore do not interpret the extent of protection or the scope of the embodiments.

In the Figures, reference 10 denotes on the whole a generally elongate lighting module, e.g. a so-called "flex module".

In one or more embodiments, device 10 may include an elongate housing 12 (so-called "track"), having e.g. a channel-shaped profile, and therefore including a web portion 120 and two side portions 122 extending sidewise of web portion 120 along the lengthwise extension of housing 12.

A device 10 as presently exemplified is adapted to be implemented, in one or more embodiments, as an elongate module (having the shape e.g. of a bar or a ribbon), which may optionally be flexible and/or adapted to be cut to length according to the application and use needs.

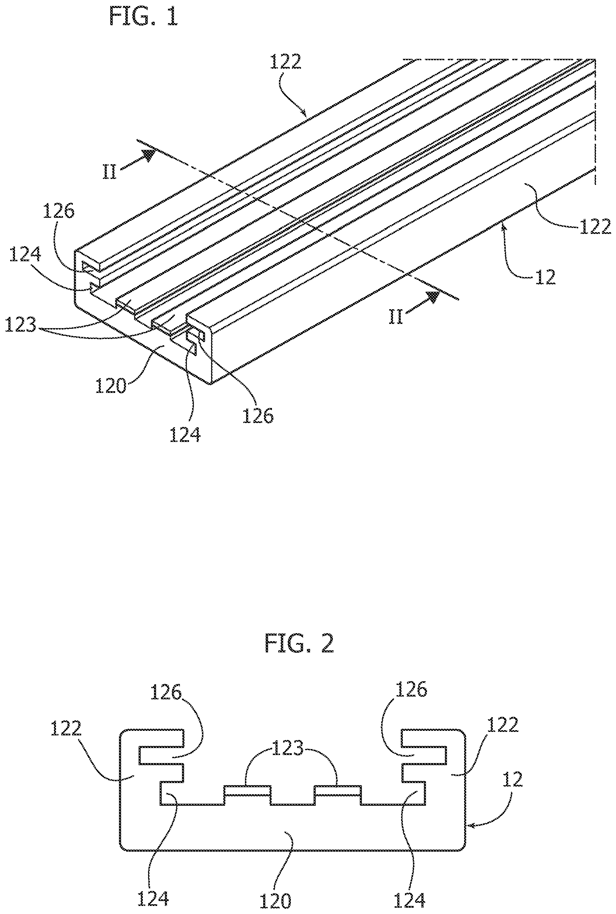

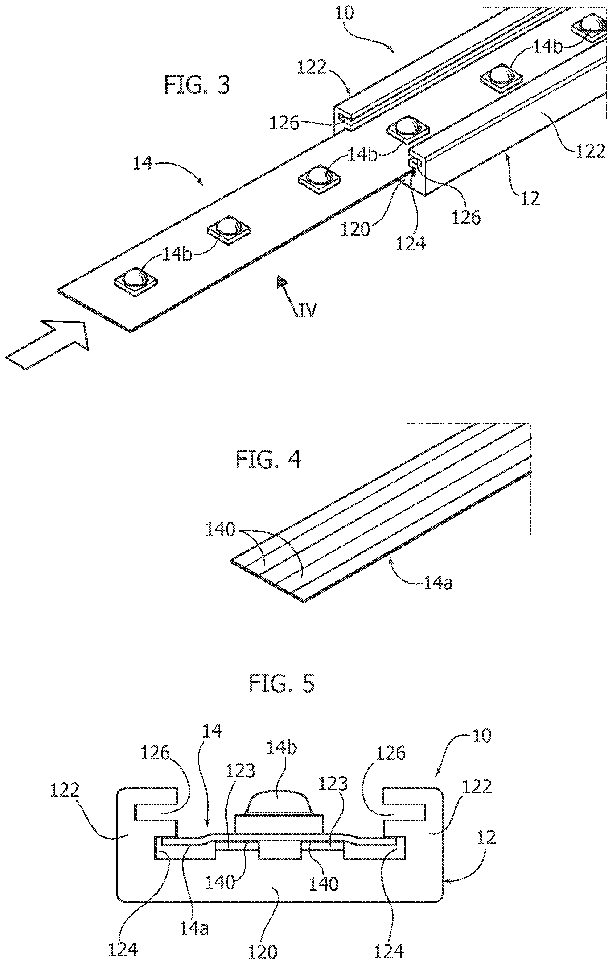

Therefore, device 10 may be considered as an element of indefinite length, with Figures such as Figure 5 (and, with reference to one of the components, Figure 2) corresponding to a section crosswise of the main extension direction.

In one or more embodiments, housing 12 may be comprised of an electrically non-conductive material (e.g. extruded plastic material, silicon, glass) and may be provided with one or more electrically conductive lines 123 extending along web portion 120 of housing 12, internally of the channel shape thereof.

In one or more embodiments, electrically conductive lines 123 (in the shown case two lines, but their number may be chosen at will) may be obtained, for example:
- via co-extrusion of an electrically conductive material (such as copper, platinum, graphite or aluminium) together with the material which forms housing 12, and/or
- by laminating line(s) 123 onto housing 12, e.g. by achieving adhesion via glues or adhesive tapes.

In one or more embodiments as exemplified herein, electrically conductive lines 123 may be carried by web portion 120 and may be comprised of formations in relief with respect to the surface of web portion 120 facing inwardly of channel-shaped profile of housing 12. In one or more embodiments, while keeping the feature of the extension along web portion 120, electrically conductive lines 14 may be carried by side walls 122.

As exemplified in Figures 3 to 5, housing 12 is adapted to receive a light radiation source assembly 14 therein.

In one or more embodiments, assembly 14 may include an elongate support board 14a having a back surface or side (the lower surface in the views of Figure 3 and Figure 5) facing web portion 120 and electrically conductive lines 123, as well as a front surface or side mounting one or more electrically-powered light radiation sources 14b, e.g. solid-state light radiation sources such as LED sources.

As can be seen in Figure 4 (corresponding to a bottom view of Figure 3, along arrow IV of Figure 3), support board 14a may be provided, on the back surface thereof, of respective electrically conductive lines 140, that are adapted to make sliding contact with electrically conductive lines 123, as visible in the cross-section view of Figure 5.

In one or more embodiments, the lateral sides of board 14a may be configured (e.g. by making use of the flexibility features of board 14a, which is substantially similar to a Printed Circuit Board, or PCB), in such a way as to extend in proximal grooves 124, opening inwardly of the channel shape of housing 12, and extending along the length of housing 12 on the sides of web portion 120.

The grooves 124 are defined as "proximal" because, in one or more embodiments, side portions 122 of housing 12 may be provided with two further grooves 126, which are located in a "distal" position with respect to grooves 124, and the function whereof will become clearer in the following.

The electrically conductive lines 140 provided on the back surface of board 14a are in electrical contact with light radiation sources 14b.

The light radiation emission assembly 14 may therefore be inserted into housing 12 e.g. by sliding lateral sides of board 14a along grooves 124 (see e.g. Figure 3), the electrically conductive lines 123 and the electrically conductive lines 140 being in mutual sliding contact.

In one or more embodiments, the properties of board 14a (for example the flexibility thereof) enable such sliding insertion while providing a sufficient stiffness to keep in position the light radiation source assembly 14 within housing 12.

In one or more embodiments, in order to achieve a good electrical contact between electrically conductive lines 123 and electrically conductive lines 140, it is possible to perform surface treatments such as a gold finishing.

The presently exemplified mounting arrangement leads to an interference fit sufficient to ensure a firm retention of the light radiation source assembly 14 within housing 12, without the use of clips or other additional elements.

In one or more embodiments, the power supply to radiation sources 14b (and optionally the transmission of electrical signals for control, thermal sensing etc. from and to such sources) may be implemented through electrically conductive lines 140 which, in the same way as electrically conductive lines 123, may be provided in any number, according to the application needs.

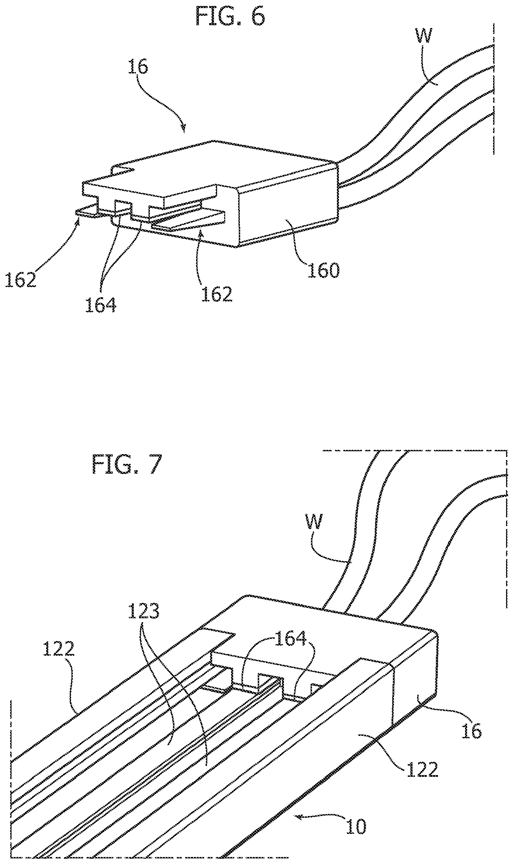

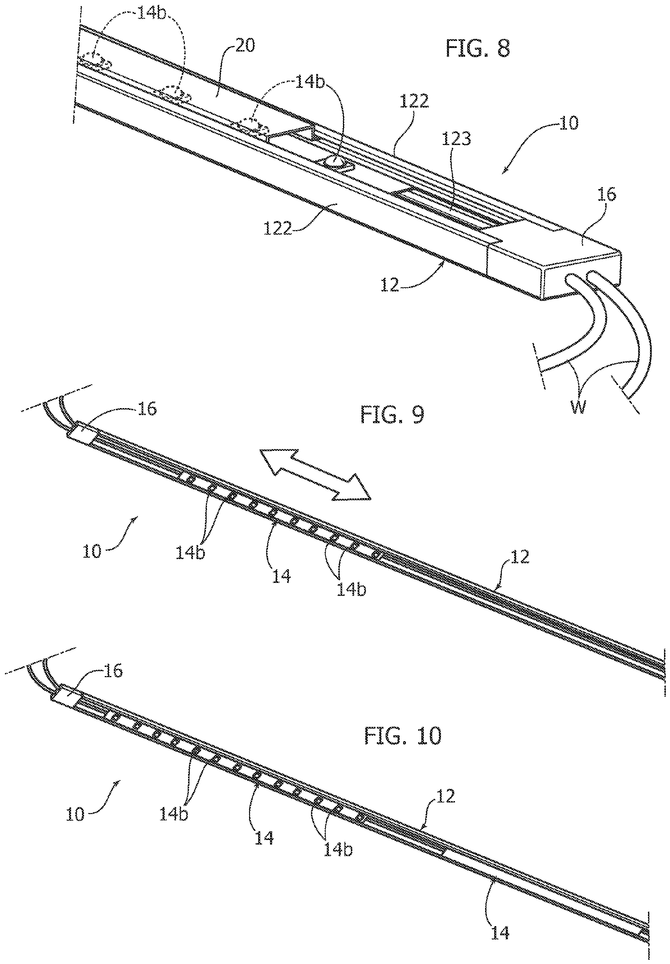

In one or more embodiments, device 10 may be associated with a connector 16, as shown in Figures 6 and 7. Such a connector 16, provided with electrical wires or cables W, may include a body 160 having a particular shape, with side pins 162 adapted to be inserted plug-like into the distal grooves 126 of housing 12, e.g. when the connector 16 has been inserted into one end of device 10 (see for example Figure 8).

In one or more embodiments, connector 16 may comprise one or more electrical contact parts 164 adapted to rest, thus achieving electrical contact, on electrically conductive lines 123 when connector 16 is fitted in device 10.

In this way (through lines 123 and lines 140) electrical connection may be established between wires or cables W and light radiation sources 14b, and the mechanical connection of connector 16 to device 10 (specifically the retention of connector 16 on device 10) may be obtained thanks to the interference fit of pins 162 within distal grooves 126.

Figures 8 to 10 exemplify the possibility of inserting light radiation source assemblies 14 into a housing 12 by making them slide lengthwise with respect to housing 12.

In this way, for example, the mounting position of an assembly 14 with respect to housing 12 may be varied (see e.g. the double arrow in Figure 9), even though the assembly is already installed e.g. on a wall or a ceiling.

Moreover, a housing 12 may receive assemblies 14 having different features, e.g. as regards the following characteristics:
- lumen output, which may be e.g. high, medium or low;
- colour temperature, which may be e.g. warm (2700K- 3000K), neutral (4000K) or cold (5000K-6000K);
- different colours of the emitted light radiation, e.g. white, blue, red, green, yellow, orange;
- pitch between LEDs 14b, which may be large or short according to needs;
- length of assembly 14, which may be selected according to use requirements.

Figure 10 shows the possibility of mounting on one and the same housing 12 two different light radiation source assemblies 14, e.g. the former emitting blue light and the latter emitting warm white light and being for example covered by a diffusive screen 20 (see for example Figure 8) adapted to mask sources 14a from the outside.

Such applications may be advantageous e.g. in showrooms and showcases, making it possible to adapt the light to the displayed objects, and optionally to adjust the position wherein the light radiation source assembly is located.

Figure 8 exemplifies the possibility of inserting, into the front portion of device 10, by making use e.g. of distal grooves 126, accessories such as a diffusive screen 20 or optics having various types of lenses.

Of course, without prejudice to the basic principles, the implementation details and the embodiments may vary, even appreciably, with respect to what has been described herein by way of non-limiting example only, without departing from the extent of protection.

The extent of protection is defined by the annexed claims.

## Claims

1. A flexible lighting device (10), including:
- a channel-shaped elongate housing (12) with a web portion (120) and two side portions (122) extending along said elongate housing (12) sidewise of said web portion (120), wherein each said side portion (122) includes, facing inwardly of the channel shape of said elongate housing (12), a proximal groove (124) extending along said elongate housing (12) sidewise of said web portion (120)
- electrically conductive line means (123) extending along said web portion (120) internally of the channel shape of said elongate housing (12), and
- a light radiation source assembly (14) including:
- i) a support board (14a) having a back surface facing said web portion (120) of said elongate housing (12) with respective electrically conductive line means (140) making electrical contact with said electrically conductive line means (123) and a front surface facing outwardly of the channel shape of said elongate housing (12), said support board (14a) having lateral sides extending into said proximal grooves (124) in said side portions (122) of said elongate housing (12); and
- ii) at least one electrically-powered light radiation source (14b) on said front surface, said at least one light radiation source (14b) in electrical contact with said respective electrically conductive line means (140),
**characterized in that** each side portion (122) includes, facing inwardly of the channel shape of said elongate housing (12), a distal groove (126) extending along said elongate housing (12) distally of said proximal groove (124), the flexible lighting device (10) further including:
- at least one electrical connector (16) having insertion formations (162) insertable plug-like into said distal grooves (126) in said side portions (122) of said elongate housing (12), said connector (16) being provided with electrical contact parts (164) for making electrical contact with said electrically conductive line means (123) extending along said web portion (120) internally of said channel shape of the elongate housing (12).

2. The lighting device of claim 1, wherein said electrically conductive line means (123) are carried by said web portion (120) of said elongate housing (12).

3. The lighting device of claim 2, wherein said electrically conductive line means (123) extend in relief with respect to said web portion (120) of said elongate housing (12).

4. The lighting device of any of the previous claims, wherein said at least one light radiation source (14b) is a solid-state light radiation source, preferably a LED source.

5. A method of producing a flexible lighting device, the method including:
- providing a channel-shaped elongate housing (12) with a web portion (120) and two side portions (122) extending along said elongate housing (12) sidewise of said web portion (120), wherein each said side portion (122) includes, facing inwardly of the channel shape of said elongate housing (12), a proximal groove (124) extending along said elongate housing (12) sidewise of said web portion (120) and a distal groove (126) extending along said elongate housing (12) distally of said proximal groove (124),
- providing electrically conductive line means (123) extending along said web portion (120) internally of the channel shape of said elongate housing (12), and
- inserting into said elongate housing (12) a light radiation source assembly (14) including:
- i) a support board (14a) having a back surface facing said web portion (120) of said elongate housing (12) with respective electrically conductive line means (140) making electrical contact with said electrically conductive line means (123) and a front surface facing outwardly of the channel shape of said elongate housing (12), said support board (14a) having lateral sides extending into said proximal grooves (124) in said side portions (122) of said elongate housing (12); and
- ii) at least one electrically-powered light radiation source (14b) on said front surface, said at least one light radiation source (14b) in electrical contact with said respective electrically conductive line means (140),
- inserting plug-like, into said distal grooves (126) in said side portions (122) of said elongate housing (12), at least one electrical connector (16) having insertion formations (162), said connector (16) being provided with electrical contact parts (164) for making electrical contact with said electrically conductive line means (123) extending along said web portion (120) internally of said channel shape of the elongate housing (12), and
- inserting a diffusive screen (20) at said front surface of device (10) via said distal grooves (126).

## Patentansprüche

1. Flexible Beleuchtungsvorrichtung (10), beinhaltend:
- ein kanalförmiges längliches Gehäuse (12) mit einem Stegabschnitt (120) und zwei Seitenabschnitten (122), die sich entlang des länglichen Gehäuses (12) seitlich des Stegabschnitts (120) erstrecken, wobei jeder der Seitenabschnitte (122) eine proximale Nut (124) beinhaltet, die sich entlang des länglichen Gehäuses (12) seitlich des Stegabschnitts (120) erstreckt, die nach innen der Kanalform des länglichen Gehäuses (12) gerichtet ist,
- elektrisch leitfähige Leitungsmittel (123), das sich entlang des Stegabschnitts (120) innerhalb der Kanalform des länglichen Gehäuses (12) erstreckt, und
- Lichtstrahlungsquellenanordnung (14), beinhaltend:
- i) eine Trägerplatte (14a) mit einer dem Stegabschnitt (120) des länglichen Gehäuses (12) zugewandten Rückfläche mit entsprechenden elektrisch leitenden Leitungsmitteln (140), die einen elektrischen Kontakt mit den elektrisch leitenden Leitungsmitteln (123) herstellen, und einer der Kanalform des länglichen Gehäuses (12) zugewandten Vorderfläche, wobei die Trägerplatte (14a) Seitenseiten aufweist, die sich in die proximalen Nuten (124) in den Seitenabschnitten (122) des länglichen Gehäuses (12) erstrecken; und
- ii) mindestens eine elektrisch betriebene Lichtstrahlungsquelle (14b) auf der Vorderseite, wobei die mindestens eine Lichtstrahlungsquelle (14b) in elektrischem Kontakt mit den jeweiligen elektrisch leitenden Leitungsmitteln (140) steht, **gekennzeichnet dadurch, dass** jeder Seitenabschnitt (122) eine distale Nut (126) beinhaltet, die sich entlang des langgestreckten Gehäuses (12) distal der proximalen Nut (124) erstreckt, die flexible Beleuchtungsvorrichtung (10) weiterhin beinhaltend:
- Mindestens einen elektrischen Verbinder (16) mit Einsteckformationen (162), die steckbar in die distalen Nuten (126) in den Seitenabschnitten (122) des langgestreckten Gehäuses (12) einsteckbar sind, wobei der Verbinder (16) mit elektrischen Kontaktteilen (164) zum Herstellen eines elektrischen Kontakts mit der elektrischen Verbindung versehen ist. Elektrisch leitfähige Leitungsmittel (123), die sich entlang des Stegabschnitts (120) innerhalb der Kanalform des länglichen Gehäuses (12) erstrecken.

2. Beleuchtungsvorrichtung nach Anspruch 1, wobei die elektrisch leitfähigen Leitungsmittel (123) von dem Stegabschnitt (120) des länglichen Gehäuses (12) getragen werden.

3. Beleuchtungsvorrichtung nach Anspruch 2, wobei sich die elektrisch leitfähigen Leitungsmittel (123) in Relief bezüglich des Stegabschnitts (120) des länglichen Gehäuses (12) erstrecken.

4. Beleuchtungsvorrichtung nach einem der vorhergehenden Ansprüche, wobei die mindestens eine Lichtstrahlungsquelle (14b) eine Festkörperlichtstrahlungsquelle, vorzugsweise eine LED-Quelle, ist.

5. Verfahren zur Herstellung einer flexiblen Beleuchtungsvorrichtung, das Verfahren beinhaltend:
- Bereitstellen eines kanalförmigen langgestreckten Gehäuses (12) mit einem Stegabschnitt (120) und zwei Seitenabschnitten (122), die sich entlang des langgestreckten Gehäuses (12) seitlich des Stegabschnitts (120) erstrecken, wobei jeder der Seitenabschnitte (122) eine proximale Nut (124), die sich entlang des langgestreckten Gehäuses (12) seitlich des Stegabschnitts (120) erstreckt, und eine distale Nut (126), die sich entlang des langgestreckten Gehäuses (12) distal der proximalen Nut (124) erstreckt, beinhaltet,
- Bereitstellen elektrisch leitfähiger Leitungsmittel (123), die sich entlang des Stegabschnitts (120) innerhalb der Kanalform des länglichen Gehäuses (12) erstrecken, und
- Einsetzen einer Lichtstrahlungsquellenanordnung (14) in das längliche Gehäuse (12), beinhaltend:
- i) eine Trägerplatte (14a) mit einer dem Stegabschnitt (120) des länglichen Gehäuses (12) zugewandten Rückfläche mit entsprechenden elektrisch leitenden Leitungsmitteln (140), die einen elektrischen Kontakt mit den elektrisch leitenden Leitungsmitteln (123) herstellen, und einer der Kanalform des länglichen Gehäuses (12) zugewandten Vorderfläche, wobei die Trägerplatte (14a) Seitenseiten aufweist, die sich in die proximalen Nuten (124) in den Seitenabschnitten (122) des länglichen Gehäuses (12) erstrecken; und
- ii) mindestens eine elektrisch betriebene Lichtstrahlungsquelle (14b) auf der Vorderseite, wobei die mindestens eine Lichtstrahlungsquelle (14b) in elektrischem Kontakt mit den jeweiligen elektrisch leitenden Leitungsmitteln (140) steht,
- Steckermäßiges Einsetzen eines mindestens eines elektrischen Verbinders (16) mit Einlegeformationen (162) in die distalen Nuten (126) in den Seitenabschnitten (122) des länglichen Gehäuses (12), wobei der Verbinder (16) mit elektrischen Kontaktteilen (164) zum Herstellen eines elektrischen Kontakts mit den elektrisch leitenden Leitungsmitteln (123) versehen ist, die sich entlang des Stegabschnitts (120) innerhalb der Kanalform des länglichen Gehäuses (12) erstrecken, und
- Einsetzen eines Diffusionsschirms (20) an der Vorderfläche der Vorrichtung über die distalen Nuten (126).

## Revendications

1. Un dispositif d'éclairage flexible (10), comprenant :
- un boitier allongé en forme de goulotte (12) avec une partie d'âme (120) et deux parties latérales (122) s'étendant le long dudit boitier allongé (12) latéralement par rapport à ladite partie d'âme (120), chacune desdites parties latérales (122) comprenant, tournée vers l'intérieur de la forme en goulotte dudit boitier allongé (12), une gorge proximale (124) s'étendant le long dudit boitier allongé (12) latéralement par rapport à ladite partie d'âme (120),
- un moyen de ligne électriquement conductrice (123) s'étendant le long de ladite partie d'âme (120) en interne par rapport à la forme de goulotte dudit boitier allongé (12), et
- un bloc source de rayonnement lumineux (14) comprenant :
- i) une carte support (14a) avec une surface dorsale tournée vers ladite partie d'âme (120) dudit boitier allongé (12) avec un moyen de ligne électriquement conductrice respectif (140) qui assure un contact électrique avec ledit moyen de ligne électriquement conductrice (123) et une surface frontale tournée vers l'extérieur de la forme en goulotte dudit boitier allongé (12), ladite carte support (14a) ayant des côtés latéraux s'étendant à l'intérieur desdites gorges proximales (124) dans lesdites parties latérales (122) dudit boitier allongé (12) ; et
- ii) au moins une source de rayonnement lumineux électriquement alimentée (14b) sur ladite surface frontale, ladite au moins une source de rayonnement lumineux (14b) étant en contact électrique avec ledit moyen de ligne électriquement conductrice respectif (140),
**caractérisé en ce que** chaque partie latérale (122) comprend, tournée vers l'intérieur de la forme en goulotte dudit boitier allongé (12), une gorge distale (126) s'étendant le long dudit boitier allongé (12) distalement par rapport à ladite gorge proximale (124), le dispositif d'éclairage flexible (10) comprenant en outre :
- au moins un connecteur électrique (16) avec des formes d'insertion (162) pouvant être insérées à la manière d'une fiche dans lesdites gorges distales (126) desdites parties latérales (122) dudit boitier allongé (12), ledit connecteur (16) étant muni de parties de contact électrique (164) pour assurer un contact électrique avec ledit moyen de ligne électriquement conductrice (123) s'étendant le long de ladite partie d'âme (120) à l'intérieur de ladite forme en goulotte du boitier allongé (12).

2. Le dispositif d'éclairage de la revendication 1, dans lequel ledit moyen de ligne électriquement conductrice (123) est porté par ladite partie d'âme (120) dudit boitier allongé (12).

3. Le dispositif d'éclairage de la revendication 2, dans lequel ledit moyen de ligne électriquement conductrice (123) s'étend en relief par rapport à ladite partie d'âme (120) dudit boitier allongé (12).

4. Le dispositif d'éclairage de l'une des revendications précédentes, dans lequel ladite au moins une source de rayonnement (14b) est une source de rayonnement lumineux à l'état solide, de préférence une source LED.

5. Un procédé de production d'un dispositif d'éclairage flexible, le procédé comprenant :
- l'obtention d'un boitier allongé en forme de goulotte (12) avec une partie d'âme (120) et deux parties latérales (122) s'étendant le long dudit boitier allongé (12) latéralement par rapport à ladite partie d'âme (120), chacune desdites parties latérales (122) comprenant, tournée vers l'intérieur de la forme en goulotte dudit boitier allongé (12), une gorge proximale (124) s'étendant le long dudit boitier allongé (12) latéralement par rapport à ladite partie d'âme (120) et une gorge distale (126) s'étendant le long dudit boitier allongé (12) distalement par rapport à ladite gorge proximale (124),
- l'obtention d'un moyen de ligne électriquement conductrice (123) s'étendant le long de ladite partie d'âme (120) en interne par rapport à la forme de goulotte dudit boitier allongé (12), et
- l'insertion dans ledit boitier allongé (12) d'un bloc source de rayonnement lumineux (14) comprenant :
- i) une carte support (14a) avec une surface dorsale tournée vers ladite partie d'âme (120) dudit boitier allongé (12) avec un moyen de ligne électriquement conductrice respectif (140) qui assure un contact électrique avec ledit moyen de ligne électriquement conductrice (123) et une surface frontale tournée vers l'extérieur de la forme en goulotte dudit boitier allongé (12), ladite carte support (14a) ayant des côtés latéraux s'étendant à l'intérieur desdites gorges proximales (124) dans lesdites parties latérales (122) dudit boitier allongé (12) ; et
- ii) au moins une source de rayonnement lumineux électriquement alimentée (14b) sur ladite surface frontale, ladite au moins une source de rayonnement lumineux (14b) étant en contact électrique avec ledit moyen de ligne électriquement conductrice respectif (140),
- l'insertion à la manière d'une fiche, dans lesdites gorges distales (126) desdites parties latérales (122) dudit boitier allongé (12), d'au moins un connecteur électrique (16) avec des formes d'insertion (162), ledit connecteur (16) étant muni de parties de contact électrique (164) pour assurer un contact électrique avec ledit moyen de ligne électriquement conductrice (123) s'étendant le long de ladite partie d'âme (120) à l'intérieur de ladite forme en goulotte du boitier allongé (12), et
- l'insertion d'un écran diffuseur (20) au niveau de ladite surface frontale du dispositif via lesdites gorges distales (126).
